# EUROPEAN PATENT APPLICATION

(11) **EP 4 629 788 A1**
(43) Date of publication of application: **08.10.2025**
(21) Application number: 25162707.1
(22) Date of filing: 10.03.2025
(51) Int. Cl.: H10F 77/30, H10F 71/00, H10F 10/142

(54) **SOLAR CELL, TANDEM SOLAR CELL, AND PHOTOVOLTAIC MODULE**

(30) Priority: 01.04.2024 CN 202410391129
(71) Applicant: Jinko Solar (Haining) Co., Ltd., Haining City, Zhejiang (CN); ZHEJIANG JINKO SOLAR CO., LTD., Haining, Zhejiang 314416 (CN)
(72) Inventor: CUI, Wei, Haining City (CN); ZHANG, Bike, Haining City (CN); LIAO, Guangming, Haining City (CN); JIN, Jingsheng, Haining City (CN); ZHANG, Bo, Haining City (CN); LI, Xiangning, Haining City (CN); ZHANG, Han, Haining City (CN); DANG, Ying, Haining City (CN); LEI, Zhenzhen, Haining City (CN)
(74) Representative: Balder IP Law, S.L.

(57) **Abstract**

Embodiments of the present disclosure relate to the field of photovoltaics, and provide a solar cell, a tandem solar cell, and a photovoltaic module. The solar cell is formed by a segmented solar cell having a segmentation surface formed in a segmenting process, and includes a passivation stack at least formed on the segmentation surface. The passivation stack includes at least a first passivation layer and a second passivation layer formed over the first passivation layer in a first direction away from the segmentation surface, and the first passivation layer includes a silicon oxide material, the second passivation layer includes a metal oxide material, a metal element in the metal oxide material includes at least one element of aluminum, titanium, zinc, zirconium, hafnium, molybdenum, tungsten, or nickel. The embodiments of the present disclosure are conducive to at least improving photoelectric conversion efficiency of solar cells including segmented solar cells.

## Description

### TECHNICAL FIELD

Embodiments of the present disclosure relate to the field of photovoltaics, and in particular to a solar cell, a tandem solar cell, and a photovoltaic module.

### BACKGROUND

A photovoltaic module includes a plurality of identical solar cells connected in series and/or in parallel. A working current of an original solar cell is relatively high, and a significant resistance loss is usually resulted from this high current when flowing through the interconnecting components between the original solar cells of the photovoltaic module. In order to address the problem of relatively high power loss in the original solar cells, laser cutting technology is used to cut an original solar cell into half-cut solar cells or a plurality of pieces of segmented solar cells, and then the segmented solar cells are connected in series using conductive solder strips. In this way, compared with the current in an original solar cell, the series current is lower, and the drop in currents of the segmented solar cells can improve the power loss of the photovoltaic module.

During the laser cutting process, an original solar cell is locally melted by laser along a preset path, and then is split along the preset path under a mechanical force to achieve slicing. However, cutting edges are left on the segmented solar cells, and each cutting edge includes a respective laser damage area and a respective mechanical fracture area, causing that the silicon atoms at the cutting edges are out of the original ordered arrangement state, and there are a large amount of dangling bonds and defect states on the surfaces, which become effective recombination centers for carriers. Thus, a large number of carriers recombine at the recombination centers, which seriously reduces the photoelectric conversion efficiency of the segmented solar cells.

### SUMMARY

Embodiments of the present disclosure provide a solar cell, a tandem solar cell, and a photovoltaic module, which is at least conducive to improving photoelectric conversion efficiency of solar cells including segmented solar cells.

According to some embodiments of the present disclosure, in one aspect of the embodiments of the present disclosure, a solar cell formed by a segmented solar cell is provided, including: a passivation stack at least formed on a segmentation surface of the segmented solar cell; the passivation stack at least includes at least a first passivation layer and a second passivation layer formed over the first passivation layer in a first direction away from the segmentation surface, the first passivation layer includes a silicon oxide material, the second passivation layer includes a metal oxide material, a metal element in the metal oxide material includes at least one element of aluminum, titanium, zinc, zirconium, hafnium, molybdenum, tungsten, or nickel.

In some embodiments, the segmented solar cell is an N-cut solar cell formed by segmenting an original solar cell, N is a positive integer greater than or equal to 2, the segmented solar cell includes at least one segmentation surface, and the passivation stack is formed on each of the at least one segmentation surface.

In some embodiments, the segmented solar cell includes: a base, the base having a first main surface facing a second direction and a second main surface opposite to the first main surface, where the segmentation surface is between the first main surface and the second main surface; a non-segmented side surface between the first main surface and the second main surface; a first main passivation film formed on the first main surface; a second main passivation film formed on the second main surface; and a side passivation film formed on the side surface, the side passivation film including a same material that is included in one of the first main passivation film or the second main passivation film.

In some embodiments, the segmented solar cell includes an interdigitated back contact (IBC) solar cell, a tunnel oxide passivated contact (TOPCON) solar cell, or a passivated emitter and real cell (PERC) solar cell.

In some embodiments, the passivation stack is further formed on part of a surface of the first main passivation film away from the first main surface; and/or the passivation stack is further formed on part of a surface of the second main passivation film away from the second main surface.

In some embodiments, an area ratio of the part of the surface of the first main passivation film provided with the passivation stack to the surface of the first main passivation film is no greater than 5%; and/or an area ratio of the part of the surface provided with the passivation stack to the surface of the second main passivation film is no greater than 5%.

In some embodiments, the solar cell further includes: an edge solder pad; the edge solder pad being formed at an edge of the first main surface, and a spacing being formed between the passivation stack formed on the surface of the first main passivation film and the edge solder pad; and/or the edge solder pad being formed at an edge of the second main surface, and a spacing being formed between the passivation stack formed on the surface of the second main passivation film and the edge solder pad.

In some embodiments, the passivation stack further includes an intermediate passivation layer, the intermediate passivation layer being formed between he first passivation layer and the second passivation layer, the intermediate passivation layer and the first passivation layer both include silicon element, and the intermediate passivation layer and the second passivation layer include the same metal element.

In some embodiments, a material of the intermediate passivation layer includes an oxide of the silicon element and an oxide of the metal element.

In some embodiments, the intermediate passivation layer and the first passivation layer include first surfaces in contact with each other, and the intermediate passivation layer and the second passivation layer include second surfaces in contact with each other; a content of the silicon element at the first surface is higher than that at the second surface, and a content of the metal element at the first surface is lower than that at the second surface.

In some embodiments, along a direction directing from the first passivation layer toward the second passivation layer, the content of the silicon element in the intermediate passivation layer substantially represents a decreasing profile, and the content of the metal element in the intermediate passivation layer substantially represents an increasing profile.

In some embodiments, a thickness of the first passivation layer is less than a thickness of the intermediate passivation layer, and the thickness of the intermediate passivation layer is less than that of the second passivation layer.

In some embodiments, a thickness of the first passivation layer is in a range of 1 nm to 10 nm, a thickness of the second passivation layer is in a range of 20 nm to 100 nm, and a thickness the intermediate passivation layer is in a range of 4 nm to 15 nm.

In some embodiments, the intermediate passivation layer further includes oxygen element, and in the intermediate passivation layer, a content of the silicon element is in a range of 2% to 60%, a content of the metal element is in a range of 2% to 50%, and a content of the oxygen element is in a range of 38% to 50%.

In some embodiments, in the first passivation layer, a content of the silicon element is in a range of 60% to 98%, and a content of the oxygen element is in a range of 2% to 40%.

In some embodiments, in the second passivation layer, a content of the metal element is in a range of 45% to 65%, and a content of the oxygen element is in a range of 35% to 55%.

In some embodiments, the first passivation layer includes a third surface away from the second passivation layer and a first surface adjacent to the second passivation layer; a content of the silicon element at the third surface is higher than that at the first surface, and a content of the oxygen element at the third surface is lower than that at the first surface.

In some embodiments, the second passivation layer includes a fourth surface away from the first passivation layer and a second surface adjacent to the first passivation layer; a content of the oxygen element at the second surface is higher than that at the fourth surface, and a content of the metal element at the second surface is lower than that at the fourth surface.

According to some embodiments of the present disclosure, in another aspect of the embodiments of the present disclosure, a tandem solar cell is further provided, including: a bottom solar cell, the bottom solar cell being the solar cell according to any one of the above embodiments, the segmented solar cell having a front surface and a back surface opposite to each other along a second direction, the segmentation surface connecting the front surface and the back surface along the second direction, the second direction being a thickness direction of the segmented solar cell; and a top solar cell located on the front surface in the bottom solar cell.

According to some embodiments of the present disclosure, in yet another aspect of the embodiments of the present disclosure, a photovoltaic module is further provided, including: at least one solar cell string formed by connecting a plurality of solar cells according to any one of the above embodiments or formed by connecting a plurality of tandem solar cells according to any one of the above embodiments; at least one packaging adhesive film configured to cover a surface of the at least one solar cell string; and at least one cover plate configured to cover a surface of the packaging adhesive film away from the at least one solar cell string.

The technical solutions provided in the embodiments of the present disclosure have at least the following advantages.

On the basis of segmenting the original solar cell to form segmented solar cells with segmentation surfaces, a passivation stack is arranged on each of the segmentation surfaces, and the passivation stack is used to perform good chemical passivation and field effect passivation on the segmentation surface to reduce a probability of recombination of carriers on the segmentation surface and prolong the lifetime of the carriers, thereby improving photoelectric conversion efficiency of the segmented solar cell.

Specifically, the passivation stack is designed to include at least a first passivation layer and a second passivation layer. On the one hand, the first passivation layer includes a silicon oxide material, and the segmentation surface is well chemically passivated by the silicon oxide material. For example, by saturating dangling bonds of the segmentation surface with oxygen atoms, density of defect states of the segmentation surface is reduced, and the probability of carrier recombination is reduced by reducing recombination centers of the segmentation surface. On the other hand, the second passivation layer includes a metal oxide material, and a metal element in the metal oxide material includes at least one element of aluminum, titanium, zinc, zirconium, hafnium, molybdenum, tungsten, or nickel. By means of the metal element in the second passivation layer, the second passivation layer has high-density fixed charges, and the high-density fixed charges can generate a large electric field, thereby performing good field effect passivation on the segmentation surface. For example, great band bending is generated between the second passivation layer and the segmentation surface, which prevents migration of minority carriers to the segmentation surface and reduces concentration of the minority carriers at the segmentation surface, thereby helping to reduce a probability of recombination of majority carriers and minority carriers on the segmentation surface. In this way, the first passivation layer and the second passivation layer coordinate to significantly improve the photoelectric conversion efficiency of the segmented solar cell, thereby improving the photoelectric conversion efficiency of the solar cell.

### BRIEF DESCRIPTION OF THE DRAWINGS

One or more embodiments are exemplarily illustrated in reference to corresponding accompanying drawing(s), and these exemplary illustrations do not constitute limitations on the embodiments. Unless otherwise stated, the accompanying drawings do not constitute scale limitations. In order to illustrate the technical solutions in related technologies or in the embodiments of the present disclosure more clearly, the drawings to be used in the description of the embodiments will be briefly described below. It is obvious that the drawings mentioned in the following description are only some embodiments of the present disclosure. For those of ordinary skill in the art, other drawings may also be obtained in accordance with these drawings without any inventive effort.
FIG. 1 is a first partial cross-sectional structural view of a solar cell according to an embodiment of the present disclosure;
FIG. 2 is a schematic top view of a single original solar cell segmented into 2 segmented solar cells according to an embodiment of the present disclosure;
FIG. 3 is a schematic top view of a single original solar cell segmented into 4 segmented solar cells according to an embodiment of the present disclosure;
FIG. 4 is a schematic top view of a single original solar cell segmented into 9 segmented solar cells according to an embodiment of the present disclosure;
FIG. 5 is a second partial cross-sectional structural view of a solar cell according to an embodiment of the present disclosure;
FIG. 6 is a third partial cross-sectional structural view of a solar cell according to an embodiment of the present disclosure;
FIG. 7 is a fourth partial cross-sectional structural view of a solar cell according to an embodiment of the present disclosure;
FIG. 8 is a fifth partial cross-sectional structural view of a solar cell according to an embodiment of the present disclosure;
FIG. 9 is a sixth partial cross-sectional structural view of a solar cell according to an embodiment of the present disclosure;
FIG. 10 is a partial top view of a solar cell according to an embodiment of the present disclosure;
FIG. 11 is a seventh partial cross-sectional structural view of a solar cell according to an embodiment of the present disclosure;
FIG. 12 is a partial cross-sectional structural view of a segmented solar cell and a passivation stack in a solar cell according to an embodiment of the present disclosure;
FIG. 13 is a graph of proportions of elements in the segmented solar cell and the passivation stack shown in FIG. 12;
FIG. 14 is a partial cross-sectional structural view of a tandem solar cell according to another embodiment of the present disclosure;
FIG. 15 is a schematic partial perspective view of a photovoltaic module according to still another embodiment of the present disclosure; and
FIG. 16 is a cross-sectional structural view taken along a cross-sectional direction MM1 in FIG. 15.

### DETAILED DESCRIPTION OF THE EMBODIMENTS

As can be seen from the background, the photoelectric conversion efficiency of the solar cell after segmenting is required to be improved.

Embodiments of the present disclosure provide a solar cell, a tandem solar cell, and a photovoltaic module. In the solar cell, on the basis of segmenting the original solar cell to form segmented solar cells with segmentation surfaces, a passivation stack is arranged on each of the segmentation surfaces, and the passivation stack includes at least a first passivation layer and a second passivation layer. On the one hand, the first passivation layer includes a silicon oxide material, and the segmentation surface is well chemically passivated by the silicon oxide material. For example, by saturating dangling bonds of the segmentation surface with oxygen atoms, density of defect states of the segmentation surface is reduced, and the probability of carrier recombination is reduced by reducing recombination centers of the segmentation surface. On the other hand, the second passivation layer includes a metal oxide material, and a metal element in the metal oxide material includes at least one element of aluminum (Al), titanium (Ti), zinc (Zn), zirconium (Zr), hafnium (Hf), molybdenum (Mo), tungsten (W), or nickel (Ni). By means of the metal element in the second passivation layer, the second passivation layer has high-density fixed charges to generate a large electric field, thereby performing good field effect passivation on the segmentation surface. For example, great band bending is generated between the second passivation layer and the segmentation surface, which prevents migration of minority carriers to the segmentation surface and reduces concentration of the minority carriers at the segmentation surface, thereby helping to reduce a probability of recombination of majority carriers and minority carriers on the segmentation surface. In this way, the first passivation layer and the second passivation layer coordinate to significantly improve the photoelectric conversion efficiency of the segmented solar cell, thereby improving the photoelectric conversion efficiency of the solar cell.

In the description of the embodiments of the present disclosure, the technical terms "first", "second", and the like are merely intended to distinguish different objects, and cannot be understood as an indication or implication of relative importance or implicit indication of the number, specific sequence, or dominant-subordinate relationship of the technical features indicated. In the description of the embodiments of the present disclosure, "a plurality of" means two or more, unless otherwise specifically stated.

The term "embodiment" described herein means that specific features, structures, or characteristics described in combination with the embodiments may be incorporated in at least one embodiment of the present disclosure. Phrases appearing at various positions of the specification refer to neither the same embodiment nor separate or alternative embodiments that are mutually exclusive with other embodiments. It is explicitly and implicitly understood by those skilled in the art that the embodiments described herein may be combined with other embodiments.

In the description of the embodiments of the present disclosure, the term "and/or" herein is merely an association relationship describing associated objects, indicating that three relationships may exist. For example, A and/or B indicates that there are three cases of A alone, A and B together, and B alone. In addition, the character "/" herein generally indicates an "or" relationship between the associated objects.

In the description of the embodiments of the present disclosure, the term "a plurality of" means more than two (including two). Similarly, "a plurality of groups" means more than two groups (including two), and "a plurality of pieces" means more than two pieces (including two).

In the description of the embodiments of the present disclosure, the orientation or position relationships indicated by the technical terms "central", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential", and the like are based on the orientation or position relationships shown in the accompanying drawings and are intended to facilitate the description of the present disclosure and simplify the description only, rather than indicating or implying that the apparatus or element referred to must have a particular orientation or be constructed and operated in a particular orientation, and therefore are not to be interpreted as limiting the embodiments of the present disclosure.

In the description of the embodiments of the present disclosure, unless otherwise specified and defined explicitly, the technical terms "mount", "connect", "join", and "fix" should be understood in a broad sense, which may be, for example, a fixed connection, a detachable connection, or an integral connection; a mechanical connection or an electrical connection; or a direct connection, an indirect connection via an intermediate medium, an internal connection between two elements, or interaction between two elements. Those of ordinary skill in the art can understand specific meanings of these terms in the embodiments of the present disclosure according to specific situations.

In the drawings corresponding to the embodiments of the present disclosure, for better understanding and ease of description, a thickness and an area of a layer are exaggerated. When a component (such as a layer, film, region, or base) is described as being on another component or on a surface of another component, the component may be "directly" on the surface of the other component or there may be a third component between the two components. In contrast, when one component is described as being on the surface of another component or another component is formed on or provided on a surface of one component, there is no third component between the two components. In addition, when a component is described as being "substantially" formed on another component, it means that the component is neither formed on the entire surface (or a front surface) of the another component, nor formed on part of an edge of the entire surface.

In the description of the embodiments of the present disclosure, when a component "includes" another component, other components are not excluded and may further be included unless otherwise stated. In addition, when a component such as a layer, a film, a region, or a plate is referred to as being "on" another component, it may be "directly on" the other component (i.e., on a surface of the other component without other components therebetween), or another component may exist therebetween. In addition, when a component such as a layer, a film, a region, or a plate is "directly on" another component, or when a component such as a layer, a film, a region, or a plate is on a surface of another component, it means that no other components exist therebetween.

The terms used in the description of the embodiments herein are for describing particular embodiments only and not intended to be limiting. As used in the description of the embodiments described and in the appended claims, "component" is also intended to include the plural form unless the context clearly indicates otherwise. The component includes a component such as a layer, a film, a region, or a plate.

Various embodiments of the present disclosure will be described in detail below with reference to the accompanying drawings. However, those of ordinary skill in the art may understand that in the embodiments of the present disclosure, many technical details are provided to enable readers to better understand the embodiments of the present disclosure. However, even without these technical details and various changes and modifications based on the following embodiments, the technical solutions claimed in the embodiments of the present disclosure can still be implemented.

An embodiment of the present disclosure provides a solar cell. The solar cell provided in an embodiment of the present disclosure will be described in detail below with reference to the accompanying drawings.

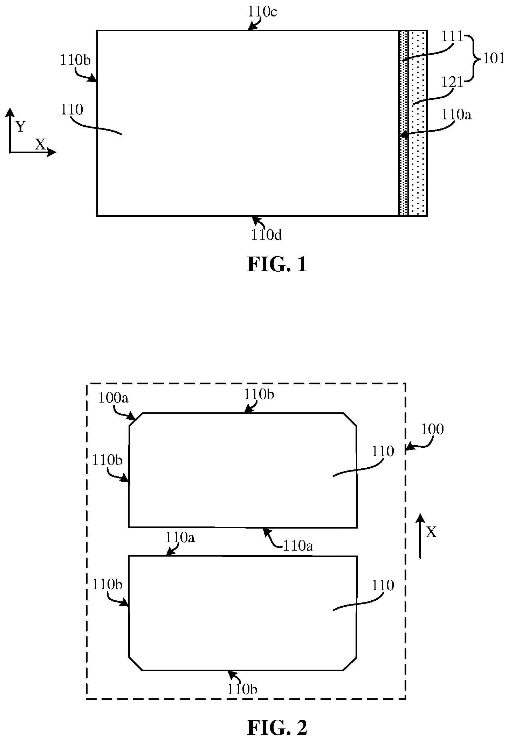

Referring to FIG. 1 or FIG. 2, the solar cell is formed by at least one segmented solar cell 110. The segmented solar cells 110 are formed by segmenting a whole solar cell 100. Each segmented solar cell 110 has a segmentation surface 110a formed in a segmenting process. The solar cell includes a passivation stack 101 at least located on the segmentation surface 110a. Along a first direction X, the passivation stack 101 includes at least a first passivation layer 111 and a second passivation layer 121. The first passivation layer 111 includes a silicon oxide material, the second passivation layer 121 includes a metal oxide material, a metal element in the metal oxide material includes at least one element of Al, Ti, Zn, Zr, Hf, Mo, W, or Ni. The first direction X is away from the segmentation surface 110a.

It should to be noted that FIG. 1 is a first partial cross-sectional structural view of a solar cell according to an embodiment of the present disclosure, and FIG. 2 is a schematic top view of a single original solar cell segmented into 2 segmented solar cells according to an embodiment of the present disclosure.

In some cases, based on segmenting, there may be a large number of dangling bonds, mechanical damage caused by the segmenting, or other surface defects on the segmentation surface 110a formed by the segmenting on the segmented solar cell 110. Moreover, based on various surface defects existing on the segmentation surface 110a, impurities are also easily introduced to the segmentation surface 110a. These defects and impurities easily serve as recombination centers for electron-hole pairs and shorten the lifetime of carriers, resulting in reduction in the photoelectric conversion efficiency of the segmented solar cell 110. It should to be noted that the segmenting includes, but is not limited to, laser cutting, and laser cutting is also prone to leaving laser damage on the segmentation surface 110a.

Based on a situation where segmenting the original solar cell 100 is segmented to form the segmented solar cell 110, the segmentation surface 110a with more surface defects may be left on the segmented solar cell 110, a passivation stack 101 is arranged on the segmentation surface 110a, and the passivation stack 101 is used to perform good chemical passivation and field effect passivation on the segmentation surface 110a to reduce a probability of recombination of carriers on the segmentation surface 110a and prolong the lifetime of the carriers, thereby improving photoelectric conversion efficiency of the segmented solar cell 110.

Specifically, in the passivation stack 110, on the one hand, the first passivation layer 111 is designed to include a silicon oxide material, and the segmentation surface 110a is chemically passivated by the silicon oxide material. For example, by saturating dangling bonds of the segmentation surface 110a with oxygen atoms on the first passivation layer 111, density of defect states of the segmentation surface 110a is reduced, and the probability of carrier recombination is reduced by reducing recombination centers of the segmentation surface 110a. On the other hand, the second passivation layer 121 is designed to include a metal oxide material, and a metal element in the metal oxide material includes at least one of an Al element, a Ti element, a Zn element, a Zr element, an Hf element, a Mo element, a W element, and an Ni element. By means of the metal element in the second passivation layer 121, the second passivation layer 121 has high-density fixed charges, and the high-density fixed charges can generate a large electric field, thereby performing good field effect passivation on the segmentation surface 110a. For example, great band bending is generated between the second passivation layer 121 and the segmentation surface 110a, which prevents migration of minority carriers to the segmentation surface 110a and reduces concentration of the minority carriers at the segmentation surface 110a, thereby helping to reduce a probability of recombination of majority carriers and minority carriers on the segmentation surface 110a. In this way, the first passivation layer 111 and the second passivation layer 121 coordinate to significantly improve the photoelectric conversion efficiency of the segmented solar cell 110, thereby improving the photoelectric conversion efficiency of the solar cell 100.

In addition, due to high density of the silicon oxide material, it is conducive to increasing density of the first passivation layer 111, so that the first passivation layer 111 has high film stability, which helps to protect the segmentation surface 110a covered by the first passivation layer 111 through the first passivation layer 111. For example, intrusion of external impurities into the segmentation surface 110a can be prevented.

Moreover, the silicon oxide material also has a good anti-PID effect. Since a packaging material of the photovoltaic module subsequently formed based on the solar cell 100 is difficult to achieve 100% isolation from the outside, in a humid environment, water vapor may enter the interior of the solar cell 100 through the packing material or a back plate used for edge banding. In this case, glass in the packaging material may produce sodium ions. The sodium ions may move to a surface of the solar cell under an external electric field, causing a PID phenomenon. As a result, the photoelectric conversion efficiency of the solar cell is reduced. However, the silicon oxide material has good density and insulation, which has a good effect on preventing entry of water vapor into the segmentation surface 110a and into the segmented solar cell 110, thereby having a good anti-PID effect. In this way, even if the packaging material of the photovoltaic module is difficult to achieve complete insulation, the water vapor enters, through the packaging material used for edge banding, an environment where the solar cell 100 is located, a film layer formed by the silicon oxide material can also prevent sodium ions in the glass in the packaging material from moving to the segmentation surface 110a, thereby preventing the PID phenomenon and keeping a photoelectric conversion rate of the solar cell 100 higher.

In some situations, along the first direction X, the first passivation layer 111 and the second passivation layer 121 are stacked on the segmentation surface 110a. Then, compared with the second passivation layer 121, the first passivation layer 111 is located closer to the segmentation surface 110a. For example, the first passivation layer 111 may cover the segmentation surface 110a. In this way, it is conducive to shortening a migration path of oxygen atoms in the first passivation layer 111 to the surface defects on the segmentation surface 110a, so as to improve a chemical passivation effect of the oxygen atoms in the first passivation layer 111 on the segmentation surface 110a. Moreover, compared with the second passivation layer 121 including the metal oxide material, lattices of the first passivation layer 111 including the silicon oxide material better match lattices of the base in the segmented solar cell 110, which helps to avoid the problem of large lattice mismatch between the segmentation surface 110a and the second passivation layer 121 when in direct contact with the second passivation layer 121, so as to avoid the problem of increased surface defects caused by lattice mismatch, thereby improving an interface passivation effect on the segmentation surface 110a.

In some embodiments, compared with a situation where after the original solar cell 100 is segmented, the segmentation surface 110a of the formed segmented solar cell 110 is not passivated, in the solar cell 100 provided in an embodiment of the present disclosure, the passivation stack 101 is formed on the segmentation surface 110a, which helps to increase an open-circuit voltage Voc of the solar cell 100 by approximately 2.5 mV, increase a fill factor (FF) by approximately 0.70%, and increase the photoelectric conversion efficiency Eff by approximately 0.28%.

The embodiments of the present disclosure will be described in more detail below with reference to the accompanying drawings.

In some embodiments, the metal element in the metal oxide material includes an Al element. That is, the second passivation layer 121 includes an aluminum oxide material. On the one hand, the aluminum oxide material enables the second passivation layer 121 to have high-density fixed negative charges (Q_{f} is about 10¹² cm⁻² to 10¹³ cm⁻²), which helps to improve a field passivation effect on the segmentation surface 110a to reduce a probability of recombination of carriers at the segmentation surface 110a, thereby helping to improve the photoelectric conversion efficiency of the segmented solar cell 110. On the other hand, in a technology of forming the second passivation layer 121 including the aluminum oxide material, there is also an appropriate amount of hydrogen ions in the second passivation layer 121, so that the second passivation layer 121 has a good hydrogen passivation effect on the segmentation surface 110a. For example, an appropriate amount of hydrogen ions in the second passivation layer 121 can effectively saturate the dangling bonds on the segmentation surface 110a through migration and can also inhibit recombination with the carriers, which helps to ensure that the carriers are effectively converged to corresponding electrodes in the segmented solar cell 110 to further improve the photoelectric conversion efficiency of the segmented solar cell 110.

In some other embodiments, the metal element in the metal oxide material includes a Mo element. That is, the second passivation layer 121 includes a molybdenum oxide material. On the one hand, the molybdenum oxide material enables the second passivation layer 121 to have a high work function, and also helps to cause the second passivation layer 121 to have a good field passivation effect on the segmentation surface 110a. On the other hand, in a technology of forming the second passivation layer 121 including the molybdenum oxide material, there is also an appropriate amount of hydrogen ions in the second passivation layer 121, so that the second passivation layer 121 has a good hydrogen passivation effect on the segmentation surface 110a.

It should to be noted that the above two embodiments are examples in which the metal oxide material in the second passivation layer 121 has a good passivation effect on the segmentation surface 110a. In practical applications, the metal element in the metal oxide material includes at least one of Al, Ti, Zn, Zr, and Hf, which can make the second passivation layer 121 have high-density fixed negative charges, so as to achieve a good field passivation effect on the segmentation surface 110a. The metal element in the metal oxide material includes at least one of Mo, W, and Ni, which can make the second passivation layer 121 have high-density fixed positive charges or a high work function, so as to achieve a good field passivation effect on the segmentation surface 110a.

In some embodiments, referring to FIG. 2, FIG. 3, or FIG. 4, each segmented solar cell 110 is an N-cut solar cell formed by segmenting the original solar cell 100, and N is a positive integer greater than or equal to 2. Each segmented solar cell 110 includes at least one segmentation surface 110a, and the passivation stack 101 is located on each segmentation surface 110a.

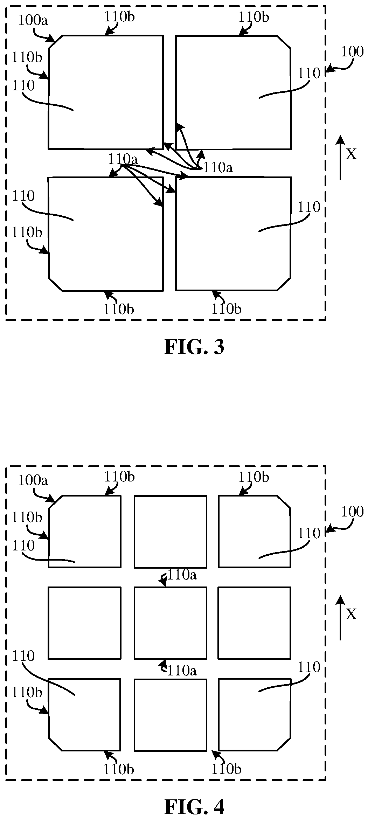

FIG. 3 is a schematic top view of a single original solar cell segmented into 4 segmented solar cells according to an embodiment of the present disclosure. FIG. 4 is a schematic top view of a single original solar cell segmented into 9 segmented solar cells according to an embodiment of the present disclosure.

In some examples, referring to FIG. 2, N is 2, and each segmented solar cell 110 is 1/2 of the whole solar cell 100. In other words, the segmented solar cell 110 is a half-cut solar cell.

In some situations, still referring to FIG. 2, chamfer designs 100a are provided at corners where four side surfaces of the original solar cell 100 are sequentially connected. Based on this, the chamfer designs 100a are still at corners where non-segmented side surfaces 110b of the segmented solar cell 110 are sequentially connected, but no chamfer design is provided at corners of the segmentation surface 110a connected to the side surfaces 110b in the segmented solar cell 110.

In some other examples, referring to FIG. 3, N is 4, and each segmented solar cell 110 is 1/4 of the original solar cell 100, in other words, is a four-cut solar cell.

In some situations, still referring to FIG. 3, a segmentation path in the original solar cell 100 is in a cross shape, and the chamfer design 100a is retained at any corner of the segmented solar cell 110.

In some other situations, the original solar cell 100 may be sequentially divided into four segmented solar cells 110 along a fixed direction, and then only the two segmented solar cells 110 each have two corners where the chamfer design 100a is retained.

In some other examples, referring to FIG. 4, N is 9, and each segmented solar cell 110 is 1/9 of the original solar cell 100, in other words, is a nine-cut solar cell.

It should to be noted that the above three examples shown in FIG. 2 to FIG. 4 are all examples in which the original solar cell 100 is segmented into N segmented solar cells 110. In practical applications, a size of N may be adjusted according to a requirement. For example, N may be 3, 5, 6, 7, 8, 10, or the like. In addition, the segmentation path by which the original solar cell 100 is segmented is not limited in the embodiments of the present disclosure, which may be flexibly adjusted according to a requirement.

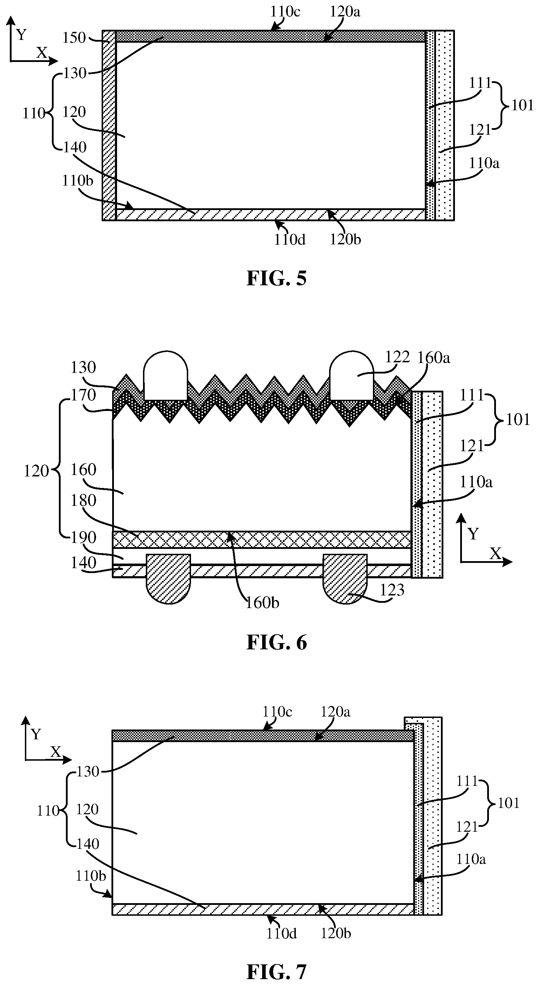

In some embodiments, referring to FIG. 2 to FIG. 4, the segmented solar cell 110 has non-segmented side surfaces 110b. Referring to FIG. 1 and FIG. 5, the segmented solar cell 110 may include: a base 120, the base 120 having a first main surface 120a facing a second direction Y and a second main surface 120b opposite to the first main surface 120a, the second direction Y being a thickness direction of the segmented solar cell 110, and the second direction Y intersecting the first direction X; a first main passivation film 130 located on the first main surface 120a; a second main passivation film 140 located on the second main surface 120b; and a side passivation film 150 located on the side surface 110b. The side passivation film 150 and the first main passivation film 130 include the same material, or the side passivation film 150 and the second main passivation film 140 include the same material.

FIG. 5 is a second partial cross-sectional structural view of a solar cell according to an embodiment of the present disclosure.

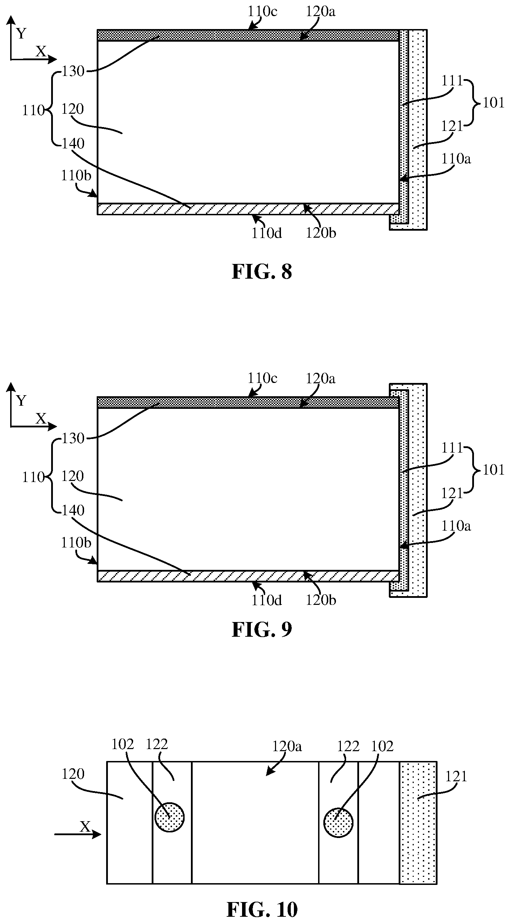

It should to be noted that referring to FIG. 2 or FIG. 3, each segmented solar cell 110 has non-segmented side surfaces 110b. In practical applications, four side surfaces of part of the segmented solar cells 110 are all the segmentation surfaces 110a formed by segmenting. For example, referring to FIG. 9, the original solar cell 100 is segmented into 9 segmented solar cells 110 in a 3*3 array arrangement, and the four side surfaces of the segmented solar cell 110 located in the middle are all the segmentation surfaces 110a.

In some examples, the side passivation film 150, the first main passivation film 130, and the second main passivation film 140 include the same material, so that the side passivation film 150, the first main passivation film 130, and the second main passivation film 140 may be formed through the same manufacturing process, which helps to simplify the manufacturing process to reduce manufacturing costs of the side passivation film 150, the first main passivation film 130, and the second main passivation film 140.

In some other examples, the first main passivation film 130 and the second main passivation film 140 may alternatively be formed through different manufacturing processes, and the side passivation film 150 may be formed through the same manufacturing process as one of the first main passivation film 130 and the second main passivation film 140.

It should to be noted that the specific structure of the side passivation film 150 is different from that of the passivation stack 101. For example, the side passivation film 150 has a single-layer structure, which is different from a stacked structure of the passivation stack 101. Alternatively, the side passivation film 150 also has a stacked structure, but materials of at least some of film layers in the side passivation film 150 are different from materials of at least some of film layers in the passivation stack 101.

In some situations, the side passivation film 150 and the passivation stack 101 may not be formed through the same manufacturing process.

In some embodiments, the side passivation film 150 may have a stacked structure of a first side passivation film, a second side passivation film, and a third side passivation film that are stacked along the first direction X. In an example, a material of the first side passivation film may include a silicon material, a material of the second side passivation film may include an aluminum oxide material, and a material of the third side passivation film may include a silicon nitride material. A thickness of the second side passivation film in the first direction X may be 5 nm.

In some embodiments, the side passivation film 150 may have a single-layer structure, and a material of the side passivation film 150 includes a silicon oxynitride material. In an example, a thickness of the side passivation film 150 in the first direction X may be 70 nm.

In some embodiments, referring to FIG. 1 or FIG. 5, the segmented solar cell 110 may have a front surface 110c and a back surface 110d that are opposite to each other along the second direction Y. The segmentation surface 110a and the side surface 110b are both connected to the front surface 110c and the back surface 110d along the second direction Y. Referring to FIG. 5, a surface of the first main passivation film 130 away from the first main surface 120a along the second direction Y is the front surface 110c, and a surface of the second main passivation film 140 away from the second main surface 120b along the second direction Y is the back surface 110d.

It should to be noted that the segmentation surface 110a and the side surface 110b not only include side surfaces of the base 120, but also include side surfaces of the first main passivation film 130 and the second main passivation film 140. In other words, the segmentation surface 110a and the side surface 110b are both side surfaces of the entire segmented solar cell 110.

In some embodiments, the segmented solar cell 110 may include an IBC (Interdigitated Back Contact) solar cell, a TOPCON (Tunnel Oxide Passivated Contact) solar cell, or a PERC solar cell (passivated emitter and rear cell).

It should to be noted that the above three types of solar cells each may include the passivation stack 101, the side passivation film 150, the first main passivation film 130, and the second main passivation film 140 in the foregoing embodiments.

The following description is based on an example in which the segmented solar cell 110 is a TOPCON solar cell.

In some embodiments, referring to FIG. 5 and FIG. 6, FIG. 6 is a third partial cross-sectional structural view of a solar cell according to an embodiment of the present disclosure. The base 120 may include: a substrate 160, the substrate 160 having a third side 160a and a fourth side 160b opposite to each other along the second direction Y, the third side 160a being adjacent to the first main surface 120a, and the fourth side 160b being adjacent to the second main surface 120b; an emitter 170 located on the third side 160a; a tunneling dielectric layer 180 located on the fourth side 160b; and a doped conductive layer 190 located on a side of the tunneling dielectric layer 180 away from the fourth side 160b. The first main passivation film 130 is located on a side of the emitter 170 away from the third side 160a, and the second main passivation film 140 is located on a side of the doped conductive layer 190 away from the tunneling dielectric layer 180.

In some situations, the substrate 160 is made of a silicon base material, such as one or more of monocrystalline silicon, polycrystalline silicon, amorphous silicon, and microcrystalline silicon. In some examples, the substrate 160 may be an N-type semiconductor base, the substrate 160 may include an N-type doping element (such as a phosphorus element, an arsenic element, or an antimony element), the emitter 170 may include a P-type doping element, and the emitter 170 and the substrate 160 form a PN junction.

In some situations, still referring to FIG. 6, the segmented solar cell 110 may further include a first electrode 122, and the first electrode 122 is in electrical contact with the emitter 170. In an example, the first electrode 122 extends through the first main passivation film 130 and is in electrical contact with the emitter 170.

In some situations, still referring to FIG. 6, the segmented solar cell 110 may further include a second electrode 123, and the second electrode 123 is in electrical contact with the doped conductive layer 190. In an example, the second electrode 123 extends through the second main passivation film 140 and is in electrical contact with the doped conductive layer 190.

In the above embodiments, in some embodiments, both the first main passivation film 130 and the second main passivation film 140 may have a single-layer structure or a stacked structure, and materials of the first main passivation film 130 and the second main passivation film 140 may be at least one of silicon oxide, silicon nitride, silicon oxynitride, silicon oxycarbonitride, titanium oxide, hafnium oxide, and aluminum oxide.

In some embodiments, the segmented solar cell 110 may further include solder pads located on the first electrode 122 and the second electrode 123, so as to facilitate subsequent use of solder strips and solder pads to achieve electrical connections between adjacent segmented solar cells 110. Part of the solder pads will be described in detail later.

It should to be noted that "the passivation stack 101 is located at least on the segmentation surface 110a" includes at least the following embodiments.

In some embodiments, referring to FIG. 7, FIG. 7 is a fourth partial cross-sectional structural view of a solar cell according to an embodiment of the present disclosure. The passivation stack 101 is further located on part of a surface of the first main passivation film 130 away from the first main surface 120a along the second direction Y. It is to be noted that in the step of forming the passivation stack 101 covering the segmentation surface 110a, raw materials required to manufacture the passivation stack 101 may diffuse by a certain distance to a surface of the first main passivation film 130 connected to the segmentation surface 110a. Therefore, the passivation stack 101 is also formed on part of the surface of the first main passivation film 130 away from the first main surface 120a along the second direction Y.

In some situations, on the surface of the first main passivation film 130 away from the first main surface 120a along the second direction Y, an area ratio of the surface provided with the passivation stack 101 to the entire surface is no greater than 5%. For example, an area ratio of a surface where the passivation stack 101 is provided on the surface of the first main passivation film 130 to the entire surface may be 4.5%, 4%, 3.5%, 3%, 2.5%, 2%, or the like. In this way, the raw materials required to manufacture the passivation stack 101 may diffuse by a short distance to the surface of the first main passivation film 130, which helps to prevent formation of the passivation stack 101 on the solder pads used to connect adjacent segmented solar cells 110, so as not to interfere with a sub-cell interconnection step during the formation of the photovoltaic module. It is to be noted that especially for a solar cell required to fully utilize the first main surface 120a, that is, increase a light-receiving area of the first main surface 120a, if grid lines on the first main surface 120a, i.e., electrodes, become thinner and thinner, or the grid lines are closer to an edge of the first main surface 120a, controlling an area ratio of a region where the passivation stack 101 is provided on the surface of the first main passivation film 130 to the entire surface is more conducive to improving conversion efficiency of the packaged photovoltaic module.

In some other embodiments, referring to FIG. 8, FIG. 8 is a fifth partial cross-sectional structural view of a solar cell according to an embodiment of the present disclosure. The passivation stack 101 is further located on part of a surface of the second main passivation film 140 away from the second main surface 120b along the second direction Y. It should to be noted that in the step of forming the passivation stack 101 covering the segmentation surface 110a, raw materials required to manufacture the passivation stack 101 may diffuse by a certain distance to a surface of the second main passivation film 140 connected to the segmentation surface 110a. Therefore, the passivation stack 101 is also formed on part of the surface of the second main passivation film 140 away from the second main surface 120b along the second direction Y.

In some situations, on the surface of the second main passivation film 140 away from the second main surface 120a along the second direction Y, an area ratio of the part of the surface of the second main passivation film 140 provided with the passivation stack 101 to the entire surface of the second main passivation film 140 is no greater than 5%. For example, an area ratio of a surface where the passivation stack 101 is provided on the surface of the first main passivation film 130 to the entire surface may be 4.5%, 4%, 3.5%, 3%, 2.5%, 2%, or the like. In this way, the raw materials required to manufacture the passivation stack 101 may diffuse by a short distance to the surface of the second main passivation film 140, which helps to prevent formation of the passivation stack 101 on the solder pads used to connect adjacent segmented solar cells 110, so as not to interfere with a sub-cell interconnection step during the formation of the photovoltaic module.

In some other embodiments, referring to FIG. 9, FIG. 9 is a sixth partial cross-sectional structural view of a solar cell according to an embodiment of the present disclosure. The passivation stack 101 is further located on part of a surface of the first main passivation film 130 away from the first main surface 120a along the second direction Y, and the passivation stack 101 is further located on part of a surface of the second main passivation film 140 away from the second main surface 120b along the second direction Y.

In some situations, on the surface of the first main passivation film 130 away from the first main surface 120a along the second direction Y, an area ratio of the part of the surface of the first main passivation film 130 provided with the passivation stack 101 to the entire surface of the first main passivation film 130 is no greater than 5%, and on the surface of the second main passivation film 140 away from the second main surface 120a along the second direction Y, an area ratio of the part of the surface of the second main passivation film 140 provided with the passivation stack 101 to the entire surface of the second main passivation film 140 is no greater than 5%.

It should to be noted that for descriptions of the solder pads in the above three embodiments, please refer to the foregoing embodiments. Details are not described herein.

In some embodiments, referring to FIG. 7 and FIG. 10, the solar cell may further include an edge solder pad 102. The edge solder pad 102 is located at an edge of the first main surface 102a, and a spacing is formed between the passivation stack 101 located on the surface of the first main passivation film 130 and the edge solder pad 102. In some other embodiments, an edge solder pad (not shown) is located at an edge of the second main surface 120b, and a spacing is formed between the passivation stack 101 located on the surface of the second main passivation film 140 and the edge solder pad. In some other embodiments, referring to FIG. 9, edge solder pads (not shown) are located at an edge of the first main surface 102a and at an edge of the second main surface 120b, and a spacing is formed between the passivation stack 101 and the edge solder pad (not shown).

In this way, it is conducive to ensuring that the passivation stack 101 may not cover the edge solder pad 102 and may not cover the solder pad in a middle region of the segmented solar cell 110, and is conducive to further preventing interference of the passivation stack 101 with the sub-cell interconnection step during the formation of the photovoltaic module.

It should to be noted that FIG. 10 is a partial cross-sectional structural of a solar cell according to an embodiment of the present disclosure. In addition, based on different types of segmented solar cells 110, the edge solder pads 102 may be located at an edge of only one of the first main surface 120a and the second main surface 120b or may be located at an edge of the first main surface 120a and at an edge of the second main surface 120b. In addition, FIG. 10 only illustrates the edge solder pads 102 located on the first electrodes 122 in an edge region. In practical applications, a first electrode located in a middle region also has solder pads, and a second electrode also has solder pads.

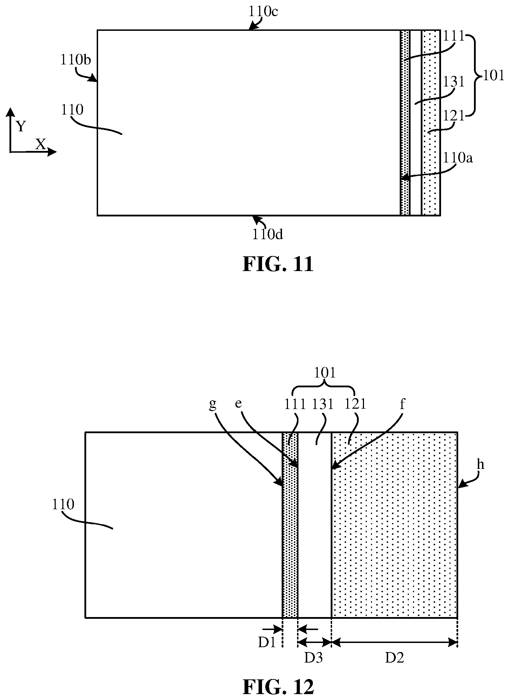

In some embodiments, referring to FIG. 11, FIG. 11 is a seventh partial cross-sectional structural view of a solar cell according to an embodiment of the present disclosure. The passivation stack 101 may further include an intermediate passivation layer 131. The intermediate passivation layer 131 is located between the first passivation layer 111 and the second passivation layer 121. The intermediate passivation layer 131 and the first passivation layer 111 both include a silicon element, and the intermediate passivation layer 131 and the second passivation layer 121 include the same metal element.

It should to be noted that the intermediate passivation layer 131 has the same element as the first passivation layer 111, that is, the silicon element, and also has the same element as the second passivation layer 121, that is, the metal element. In this way, the intermediate passivation layer 131 is conducive, by means of the silicon elements, to enabling better match between lattices at an interface where the intermediate passivation layer 131 is in contact with the first passivation layer 111, and also is conducive, by means of the metal element, to enabling better match between lattices at an interface where the intermediate passivation layer 131 is in contact with the second passivation layer 121, which helps to prevent the problem of lattice mismatch between the first passivation layer 111 and the second passivation layer 121 when the first passivation layer 111 and the second passivation layer 121 are in direct contact, so as to avoid the problem of increased surface defects caused by lattice mismatch, thereby improving an interface passivation effect of the passivation stack 101 on the segmented solar cell 110, for example, improving a passivation effect on the segmentation surface 110a.

In other words, the intermediate passivation layer 131 plays a transition role to improve adaptability of lattices at an interface where the first passivation layer 111, the intermediate passivation layer 131, and the second passivation layer 121 are in sequential contact, which prevents gaps and dislocations at the interface where the first passivation layer 111, the intermediate passivation layer 131, and the second passivation layer 121 are in sequential contact, so as to improve uniformity of films layers in the passivation stack 101, thereby improving an interface passivation effect of the passivation stack 101 on the segmented solar cell 110. Moreover, it is conducive to improving, by means of the intermediate passivation layer 131, connection strength between the first passivation layer 111 and the intermediate passivation layer 131 and connection strength between the intermediate passivation layer 131 and the second passivation layer 121, to prevent the problem of mutual slippage or detachment of the first passivation layer 111 and the intermediate passivation layer 131 or the intermediate passivation layer 131 and the second passivation layer 121, thereby improving structural stability of the passivation stack 101.

In some embodiments, a material of the intermediate passivation layer 131 may include an oxide of the silicon element and an oxide of the metal element. In this way, it can be ensured that the intermediate passivation layer 131 has the same element as the first passivation layer 111 and also has the same element as the second passivation layer 121, so that the intermediate passivation layer 131 serves as a transition layer between the first passivation layer 111 and the second passivation layer 121, and oxygen atoms in the intermediate passivation layer 131 can also be used to further saturate dangling bonds on the segmentation surface 110a based on migration of the oxygen atoms towards the segmentation surface 110a, so as to further reduce the density of defect states of the segmentation surface 110a, thereby further reducing the recombination centers of the segmentation surface 110a to reduce the probability of recombination of carriers.

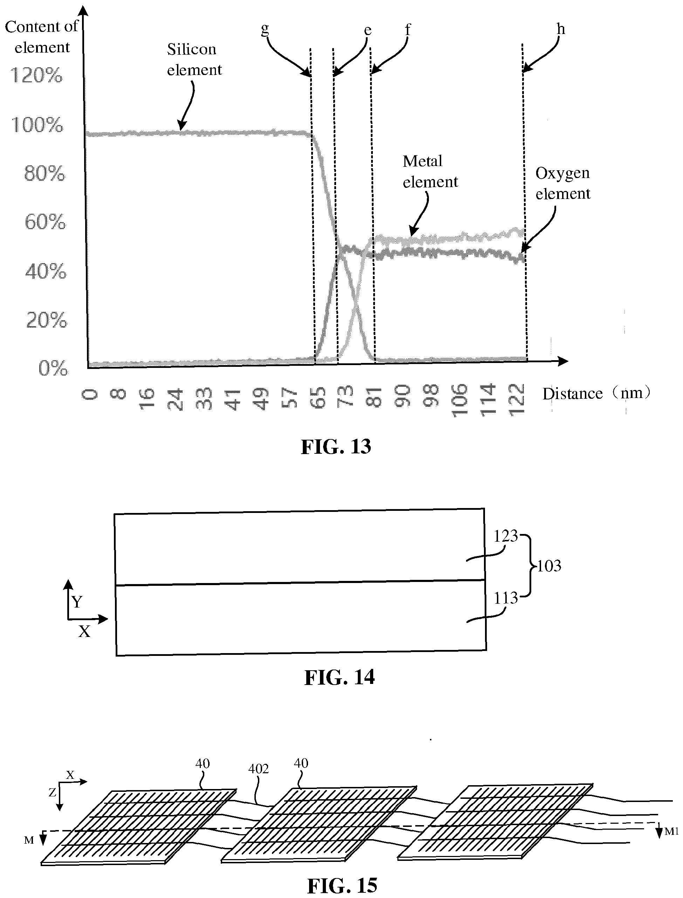

In some embodiments, referring to FIG. 12 and FIG. 13, the intermediate passivation layer 131 and the first passivation layer 111 have first surfaces e in contact, and the intermediate passivation layer 131 and the second passivation layer 121 have second surfaces f in contact. A content of the silicon element at the first surface e is higher than a content of the silicon at the second surface f, and a content of the metal element at the first surface e is lower than the content of the metal element at the second surface f.

FIG. 12 is a partial cross-sectional structural view of a segmented solar cell and a passivation stack in a solar cell according to an embodiment of the present disclosure. FIG. 13 is a graph of proportions of elements in the segmented solar cell and the passivation stack shown in FIG. 12.

It should to be noted that on the one hand, the first passivation layer 111 includes a silicon oxide material. Based on this, the content of the silicon element at the first surface e where the intermediate passivation layer 131 is in contact with the first passivation layer 111 is designed to be higher than the content at the second surface f, which, compared with the second surface f, helps to make the first surface e rich in the silicon element, thereby helping to increase the content of the silicon element at the first surface e, further improves a degree of matching between lattices at the interface where the intermediate passivation layer 131 is in contact with the first passivation layer 111, and further reduces the density of the defect states at the first surface e, thereby further improving the passivation effect of the passivation stack 101 on the segmentation surface 110a. On the other hand, the second passivation layer 121 includes a metal oxide material. Based on this, the content of the metal element at the second surface f where the intermediate passivation layer 131 is in contact with the second passivation layer 121 is designed to be higher than the content at the first surface e, which helps to make the second surface f rich in the metal element, thereby helping to increase the content of the metal element at the second surface f, further improves a degree of matching between lattices at the interface where the intermediate passivation layer 131 is in contact with the second passivation layer 121, and further reduces the density of the defect states at the second surface f, thereby further improving the passivation effect of the passivation stack 101 on the segmentation surface 110a.

In some embodiments, referring to FIG. 12 and FIG. 13, along a direction directing from the first passivation layer 111 to the second passivation layer 121, the content of the silicon element in the intermediate passivation layer 131 substantially represents a decreasing profile, and the content of the metal element in the intermediate passivation layer 131 substantially represents an increasing profile.

It should to be noted that the content of the silicon element at the first surface e is higher than that at the second surface f, and the content of the metal element at the first surface e is lower than that at the second surface f. Then, along a direction directing from the first passivation layer 111 to the second passivation layer 121, the content of the silicon element in the intermediate passivation layer 131 substantially represents a decreasing profile, and the content of the metal element in the intermediate passivation layer 131 substantially represents an increasing profile. In practice, with variation of a depth in the intermediate passivation layer 131 along the direction directing from the first passivation layer 111 to the second passivation layer 121, the content of the silicon element and the content of the metal element in the intermediate passivation layer 131 may fluctuate, i.e. do not always represent a strict decreasing profile or a strict increasing profile. However, with the variation of the depth, an overall trend of the content of the silicon element represents a decreasing profile, and an overall trend of the content of the metal element represents an increasing profile. Therefore, "substantially" refers to an overall trend of change in values hereinafter. In addition, the silicon element and the metal element in the intermediate passivation layer 131 both represent a changing profile, that is, change gradually, which helps to improve stability of performance of the intermediate passivation layer 131 and prevent sudden changes in the performance caused by sudden changes in the content of the elements in the intermediate passivation layer 131.

In some embodiments, referring to FIG. 12 and FIG. 13, the intermediate passivation layer 131 may further include an oxygen element, and along the direction directing from the first passivation layer 111 to the second passivation layer 121, a content of the oxygen element in the intermediate passivation layer 131 first represents a substantially increasing profile and then represents a substantially decreasing profile.

It should to be noted that in order to improve the degree of matching between lattices at the interface where the intermediate passivation layer 131 is in contact with the first passivation layer 111 and the degree of matching between lattices at the interface where the intermediate passivation layer 131 is in contact with the second passivation layer 121, it is designed that the first surface e where the intermediate passivation layer 131 is in contact with the first passivation layer 111 is rich in silicon elements and the second surface f where the intermediate passivation layer 131 is in contact with the second passivation layer 121 is rich in metal elements. Therefore, along the direction directing from the first passivation layer 111 to the second passivation layer 121, a peak of the content of the oxygen element in the intermediate passivation layer 131 is located in a middle part, so as to ensure that one of two ends of the intermediate passivation layer 131 is rich in silicon elements and the other is rich in metal elements. Based on this, the content of the oxygen element in the intermediate passivation layer 131 is designed to first substantially represent an increasing profile and then substantially represent a decreasing profile, so as to ensure a high passivation effect of the passivation stack 101 on the segmentation surface 110a.

It should to be noted that in some embodiments, an increasing profile of a certain parameter means that the parameter substantially gradually increases. That is, during the change, the parameter has been substantially gradually increasing. A decreasing profile of a certain parameter means that the parameter substantially gradually decreases. That is, during the change, the parameter has been substantially gradually decreasing. In some other embodiments, an increasing profile of a certain parameter means that during the change, the parameter substantially increases as a whole, while during a local change, the parameter may gradually decrease. A decreasing profile of a certain parameter means that during the change, the parameter substantially decreases as a whole, while during a local change, the parameter may gradually increase. In other embodiments, an increasing profile of a certain parameter means that the parameter substantially gradually increases, and a decreasing profile of a certain parameter means that the parameter substantially decreases as a whole, while during a local change, the parameter substantially gradually increases. Alternatively, an increasing profile of a certain parameter means that the parameter substantially increases as a whole, while during a local change, the parameter substantially gradually decreases, and a decreasing profile of a certain parameter means that the parameter substantially gradually decreases. The above parameters include, but are not limited to, the content of the silicon element in the intermediate passivation layer 131, the content of the metal element in the intermediate passivation layer 131, and the content of the oxygen element in the intermediate passivation layer 131.

In addition, FIG. 13 is only an example of a changing profile of proportions of content of the silicon element, the metal element, and the oxygen element in a partial region of the base 120 and the passivation stack 101 in the segmented solar cell. In practical applications, the change profile of the proportions of content of the silicon element, the metal element, and the oxygen element in the base 120 and the passivation stack 101 may alternatively be partially or wholly different from the example shown in FIG. 13. In an example, the metal element in FIG. 13 may be an aluminum element.

In some embodiments, a material of the intermediate passivation layer 131 may be a common oxide of the silicon element and the aluminum element, and a material of the second passivation layer 121 may be an aluminum oxide material.

In some embodiments, referring to FIG. 12, along the first direction X, a thickness D1 of the first passivation layer 111 is less than a thickness D3 of the intermediate passivation layer 131, and the thickness of the intermediate passivation layer 131 is less than a thickness D2 of the second passivation layer 121.

It is to be noted that when the first passivation layer 111 includes a silicon oxide material. When a thickness of a film layer including the silicon oxide material along the first direction X, i.e., D1, is relatively small, the first passivation layer 111 can be ensured to have a good chemical passivation effect on the segmentation surface 110a. A formation process of the first passivation layer 111 with a smaller D1 is simpler than a formation of the first passivation layer 111 with a greater thickness. In addition, when the thickness D1 of the first passivation layer 111 is smaller and the intermediate passivation layer 131 includes the oxygen element, it is also conducive to making it easier for oxygen atoms in the intermediate passivation layer 131 to migrate to the segmentation surface 110a, so as to further improve the chemical passivation effect on the segmentation surface 110a.

The intermediate passivation layer 131 serves as a transition layer between the first passivation layer 111 and the second passivation layer 121, as long as the thickness D3 of the intermediate passivation layer 131 along the first direction X is appropriate, and it is better to facilitate the migration of the oxygen atoms in the intermediate passivation layer 131 to the segmentation surface 110a. Moreover, the second passivation layer 121 includes a metal oxide material. Along the first direction X, within a certain thickness range, a greater thickness of the film layer including the metal oxide material indicates a better field effect passivation effect of the second passivation layer 121 on the segmentation surface 110a. Therefore, along the first direction X, it is designed that the thickness D2 of the second passivation layer 121 is maximum, the thickness D1 of the first passivation layer 111 is minimum, and the thickness D3 of the intermediate passivation layer 131 is between D1 and D2, which can ensure that the first passivation layer 111 has a good chemical passivation effect on the segmentation surface 110a, can also ensure that the second passivation layer 121 has a good field effect passivation effect on the segmentation surface 110a, and is conducive to the migration of the oxygen atoms in the intermediate passivation layer 131 to the segmentation surface 110a.

In some embodiments, referring to FIG. 12, along the first direction X, the thickness D1 of the first passivation layer 111 may range from 1 nm to 10 nm. In some examples, the thickness D1 of the first passivation layer 111 may range from 4 nm to 7 nm, which is, for example, 4.5 nm, 5 nm, 5.5 nm, 6 nm, 6.5 nm, or the like.

In some embodiments, referring to FIG. 12, along the first direction X, the thickness D2 of the second passivation layer 121 may range from 20 nm to 100 nm. In some examples, the thickness D2 of the second passivation layer 121 may range from 40 nm to 60 nm, which is, for example, 45 nm, 48 nm, 50 nm, 53 nm, 55 nm, 58 nm, or the like.

In some embodiments, referring to FIG. 12, along the first direction X, the thickness D3 of the intermediate passivation layer 131 may range from 4 nm to 15 nm. In some examples, the thickness D2 of the second passivation layer 121 may range from 8 nm to 12 nm, which is, for example, 8.5 nm, 9 nm, 50 nm, 9.5 nm, 10 nm, 10.5 nm, 11 nm, 11.5 nm, or the like.

In some embodiments, the intermediate passivation layer 131 may further include an oxygen element, and in the intermediate passivation layer 131, the content of the silicon element ranges from 2% to 60%, the content of the metal element ranges from 2% to 50%, and the content of the oxygen element ranges from 38% to 50%.

It is to be noted that "the content of the silicon element in the intermediate passivation layer 131 ranges from 2% to 60%" means that an average value of the content of the silicon element in the intermediate passivation layer 131 ranges from 2% to 60%, and the content of the silicon element in different regions of the intermediate passivation layer 131 may be within the average value or may not be within the average value. Similarly, "the content of the metal element in the intermediate passivation layer 131 ranges from 2% to 50%" means that an average value of the content of the metal element in the intermediate passivation layer 131 ranges from 2% to 50%, and the content of metal elements in different regions of the intermediate passivation layer 131 may be within the average value or may not be within the average value. "The content of the oxygen element in the intermediate passivation layer 131 ranges from 38% to 50%" means that an average value of the content of the oxygen element in the intermediate passivation layer 131 ranges from 38% to 50%, and the content of oxygen elements in different regions of the intermediate passivation layer 131 may be within the average value or may not be within the average value.

In some situations, for the region with the maximum content of the silicon element in the intermediate passivation layer 131, for example, at the first surface e, the content of the silicon element in the region ranges from 40% to 80%. For example, the content of the silicon element in the region may be 60%. For the region with minimum content of the silicon element in the intermediate passivation layer 131, for example, at the second surface f, the content of the silicon element in the region may range from 2% to 5%. For example, the content of the silicon element in the region may be 3%.

In some situations, for the region with minimum content of the metal element in the intermediate passivation layer 131, for example, at the first surface e, the content of the metal element in the region ranges from 2% to 5%. For example, the content of the metal element in the region may be 3%. For the region with maximum content of the metal element in the intermediate passivation layer 131, for example, at the second surface f, the content of the metal element in the region may range from 30% to 70%. For example, the content of the metal element in the region may be 50%.

In some situations, for the region with maximum content of the oxygen element in the intermediate passivation layer 131, for example, in the middle region of the intermediate passivation layer 131, the content of the oxygen element in the region ranges from 45% to 60%. For example, the content of the oxygen element in the region may be 60%. For the region with minimum content of the oxygen element in the intermediate passivation layer 131, for example, at the first surface e or the second surface f, the content of the oxygen element in the region may range from 20% to 40%. For example, the content of the oxygen element in the region may be 20%.

It should to be noted that for the intermediate passivation layer 131, a sum of the content of the silicon element, the content of the metal element, and the content of the oxygen element may be 100% or may not be 100%. In a case where the sum of the content of the silicon element, the content of the metal element, and the content of the oxygen element is not 100%, the intermediate passivation layer 131 may further include other impurity elements, such as hydrogen, so that the intermediate passivation layer 131 further has a hydrogen passivation effect on the segmentation surface 110a. It should to be noted that in a technology of forming the second passivation layer 121, the second passivation layer 121 may include other impurity elements in addition to the silicon element, the oxygen element, and the metal element.

In some embodiments, referring to FIG. 12 and FIG. 13, along the first direction X, the first passivation layer 111 has a third surface g away from the second passivation layer 121 and a first surface e adjacent to the second passivation layer 121. A content of the silicon element at the third surface g is higher than that at the first surface e, and a content of the oxygen element at the third surface g is lower than that at the first surface e.

It should to be noted that the third surface g is an interface where the first passivation layer 111 is in contact with the segmentation surface 110a. Most region of the segmentation surface 110a is formed by side surfaces of the substrate 160 in the segmented solar cell 110, and the substrate 160 may be made of a silicon base material. Based on this, the content of the silicon element at the third surface g where the first passivation layer 111 is in contact with the segmentation surface 110a is designed to be higher than the content at the first surface e, which, compared with the first surface e, helps to make the third surface g rich in the silicon element, thereby helping to increase the content of the silicon element at the third surface g, further improves a degree of matching between lattices at the interface where the first passivation layer 111 is in contact with the segmentation surface 110a, and further reduces the density of the defect states at the third surface g, thereby further improving the passivation effect of the first passivation layer 111 on the segmentation surface 110a. Moreover, in order to make the content of the silicon element at the third surface g higher than the content at the first surface e, the content of the oxygen element at the third surface g is designed to be lower than the content at the first surface e to ensure a higher passivation effect of the first passivation layer 111 on the segmentation surface 110a.

In some embodiments, referring to FIG. 12 and FIG. 13, along the direction directing from the first passivation layer 111 toward the second passivation layer 121, the content of the silicon element in the first passivation layer 111 substantially represents a decreasing profile, and the content of the oxygen element in the first passivation layer 111 substantially represents an increasing profile. In this way, the silicon element and the oxygen element in the first passivation layer 111 both represent a changing profile, that is, change gradually, which helps to improve stability of performance of the first passivation layer 111 and prevent sudden changes in the performance caused by sudden changes in the content of the elements in the first passivation layer 111.

It should to be noted that "represent an increasing profile", "specific situations included in representing the increasing profile", "represent a decreasing profile", "specific situations included in representing the decreasing profile" have been described in detail above. Herein, the related descriptions of "the content of the silicon element in the first passivation layer 111 represents a decreasing profile and the content of the oxygen element in the first passivation layer 111 represents an increasing profile" are not described in detail.

In some embodiments, referring to FIG. 12 and FIG. 13, along the first direction X, the second passivation layer 121 has a fourth surface h away from the first passivation layer 111 and a second surface f adjacent to the first passivation layer 111. A content of the oxygen element at the second surface f is higher than that at the fourth surface h, and a content of the metal element at the second surface f is lower than that at the fourth surface h.

It should to be noted that whether the first passivation layer 111 and the second passivation layer 121 are in direct contact or there is an intermediate passivation layer 131 between the first passivation layer 111 and the second passivation layer 121, the content of the oxygen element at the second surface f is designed to be higher than the content at the fourth surface h, which, compared with the fourth surface h, helps to make the second surface f rich in the oxygen element, thereby being conducive to migration of more oxygen atoms to the segmentation surfaces 110a to improve the passivation effect of the passivation stack 101 on the segmentation surface 110a. Moreover, in order to make the content of the oxygen element at the second surface f higher than the content at the fourth surface h, the content of the metal element at the second surface f is designed to be lower than the content at the fourth surface h to ensure a higher passivation effect of the second passivation layer 121 on the segmentation surface 110a.

In some embodiments, referring to FIG. 12 and FIG. 13, along the direction directing from the first passivation layer 111 to the second passivation layer 121, the content of the oxygen element in the second passivation layer 121 substantially represents a decreasing profile, and the content of the metal element in the second passivation layer 121 substantially represents an increasing profile. In this way, the oxygen element and the metal element in the second passivation layer 121 both represent a changing profile, that is, change gradually, which helps to improve stability of performance of the second passivation layer 121 and prevent sudden changes in the performance caused by sudden changes in the content of the elements in the second passivation layer 121.

It is to be noted that "represent an increasing profile", "specific situations included in representing the increasing profile", "represent a decreasing profile", "specific situations included in representing the decreasing profile" have been described in detail above. Herein, the related descriptions of "the content of the oxygen element in the second passivation layer 121 represents a decreasing profile and the content of the metal element in the second passivation layer 121 represents an increasing profile" are not described in detail.

In some embodiments, in the first passivation layer 111, the content of the silicon element ranges from 60% to 98%, and the content of the oxygen element ranges from 2% to 40%.

It should to be noted that "the content of the silicon element in the first passivation layer 111 ranges from 60% to 98%" means that an average value of the content of the silicon element in the first passivation layer 111 ranges from 60% to 98%, and the content of the silicon element in different regions of the first passivation layer 111 may be within the average value or may not be within the average value. Similarly, "the content of the oxygen element in the first passivation layer 111 ranges from 2% to 40%" means that an average value of the content of the oxygen element in the first passivation layer 111 ranges from 2% to 40%, and the content of the oxygen element in different regions of the first passivation layer 111 may be within the average value or may not be within the average value.

In some situations, for the region with maximum content of the silicon element in the first passivation layer 111, for example, at the third surface g, the content of the silicon element in the region ranges from 90% to 98%. For example, the content of the silicon element in the region may be 95%. For the region with minimum content of the silicon element in the first passivation layer 111, for example, at the first surface e, the content of the silicon element in the region may range from 40% to 80%. For example, the content of the silicon element in the region may be 60%.

In some situations, for the region with minimum content of the oxygen element in the first passivation layer 111, for example, at the third surface g, the content of the oxygen element in the region ranges from 2% to 5%. For example, the content of the oxygen element in the region may be 3%. For the region with maximum content of the oxygen element in the first passivation layer 111, for example, at the first surface e, the content of the oxygen element in the region may range from 20% to 60%. For example, the content of the oxygen element in the region may be 40%.

It should to be noted that for the first passivation layer 111, a sum of the content of the silicon element and the content of the oxygen element may be 100% or may not be 100%. In a case where the sum of the content of the silicon element and the content of the oxygen element is not 100%, the first passivation layer 111 may further include other impurity elements, such as hydrogen, so that the first passivation layer 111 further has a hydrogen passivation effect on the segmentation surface 110a. It should to be noted that in a technology of forming the first passivation layer 111, the first passivation layer 111 may include other impurity elements in addition to the silicon element, the oxygen element, and the metal element.

In some embodiments, in the second passivation layer 121, the content of the metal element ranges from 45% to 65%, and the content of the oxygen element ranges from 35% to 55%.

It should to be noted that "the content of the metal element in the second passivation layer 121 ranges from 45% to 65%" means that an average value of the content of the metal element in the second passivation layer 121 ranges from 45% to 65%, and the content of the metal element in different regions of the second passivation layer 121 may be within the average value or may not be within the average value. Similarly, "the content of the oxygen element in the second passivation layer 121 ranges from 35% to 55%" means that an average value of the content of the oxygen element in the second passivation layer 121 ranges from 35% to 55%, and the content of the oxygen element in different regions of the second passivation layer 121 may be within the average value or may not be within the average value.

In some situations, for the region with maximum content of the metal element in the second passivation layer 121, for example, at the fourth surface h, the content of the metal element in the region ranges from 55% to 75%. For example, the content of the metal element in the region may be 70%. For the region with minimum content of the metal element in the first passivation layer 111, the content of the metal element in the region may range from 25% to 50%. For example, the content of the metal element in the region may be 30%.

In some situations, for the region with minimum content of the oxygen element in the second passivation layer 121, the content of the oxygen element in the region ranges from 25% to 45%. For example, the content of the oxygen element in the region may be 30%. For the region with maximum content of the oxygen element in the second passivation layer 121, the content of the oxygen element in the region may range from 50% to 70%. For example, the content of the oxygen element in the region may be 55%.

It is to be noted that for the second passivation layer 121, a sum of the content of the silicon element and the content of the metal element may be 100% or may not be 100%. In a case where the sum of the content of the silicon element and the content of the metal element is not 100%, the second passivation layer 121 may further include other impurity elements, such as hydrogen, so that the second passivation layer 121 further has a hydrogen passivation effect on the segmentation surface 110a. It should to be noted that in a technology of forming the second passivation layer 121, the second passivation layer 121 may include other impurity elements in addition to the silicon element, the oxygen element, and the metal element.

In some embodiments, the first passivation layer 111 may be made of a SiₐO_{b} material, a/b∈[1.5, 49], where a/b represents a ratio of the content of the silicon element to the content of the oxygen element in the first passivation layer 111.

In some embodiments, the intermediate passivation layer 131 may be made of a SiAlᵢOⱼ material, i/jE[0.04, 1.31], where i/j represents a ratio of the content of the aluminum element to the content of the oxygen element in the intermediate passivation layer 131.

In some embodiments, the second passivation layer 121 may be made of an AlₘOₙ material, m/n∈[1, 1.2], where m/n represents a ratio of the content of the aluminum element to the content of the oxygen element in the second passivation layer 121.

It should to be noted that the mathematical formula SiₐO_{b} including "a" and "b" represents the ratio of the content of the silicon element to the content of the oxygen element in the first passivation layer 111. The mathematical formula SiAlᵢOⱼ including "i" and "j" represents the ratio of the content of the aluminum element to the content of the oxygen element in the intermediate passivation layer 131. The mathematical formula AlₘOₙ including "m" and "n" represents the ratio of the content of the aluminum element to the content of the oxygen element in the second passivation layer 121. SiₐO_{b}, SiAlᵢOⱼ, and AlₘOₙ are not strictly chemical formulas or structures. Therefore, each of the SiₐO_{b} material, the SiAlᵢOⱼ material, and the AlₘOₙ material may include one or more stoichiometric compounds and/or, one or more non-stoichiometric compounds. Moreover, "a" and "b" (if present) may be integers or non-integers, "i" and "j" (if present) may also be integers or non-integers, and "m" and "n" (if present) may also be integers or non-integers.

As used herein, the term "non-stoichiometric compound" means and includes a compound consisting of an element that cannot be represented by a ratio of a clearly defined natural number and does not violate the law of definite proportions. The content of each element in the first passivation layer 111, the second passivation layer 121, and the intermediate passivation layer 131 may be determined by test and measurement by using an X-ray energy dispersive spectrometer (EDS), an electron energy loss spectroscopy (EELS), or a secondary ion mass spectrometry (SIMS). For example, a specific line region or an area region may be selected for testing by using a measuring device.

Based on the above, on the one hand, the first passivation layer 111 is designed to include a silicon oxide material, and the segmentation surface 110a is chemically passivated by the silicon oxide material. On the other hand, the second passivation layer 121 is designed to include a metal oxide material, and a metal element in the metal oxide material includes at least one of Al, Ti, Zn, Zr, Hf, Mo, W, and Ni. By means of the metal element in the second passivation layer 121, the second passivation layer 121 has high-density fixed charges, and the high-density fixed charges can generate a large electric field, thereby performing good field effect passivation on the segmentation surface 110a. In this way, the first passivation layer 111 and the second passivation layer 121 coordinate to significantly improve the photoelectric conversion efficiency of the segmented solar cell 110, thereby improving the photoelectric conversion efficiency of the solar cell 100.

Another embodiment of the present disclosure further provides a tandem solar cell. The tandem solar cell includes the solar cell provided in the foregoing embodiments. The tandem solar cell provided in another embodiment of the present disclosure will be described in detail below with reference to the accompanying drawings. It is to be noted that the parts that are the same as or corresponding to the foregoing embodiments are not described again herein.

FIG. 14 is a partial cross-sectional structural view of a tandem solar cell according to another embodiment of the present disclosure.

Referring to FIG. 1 and FIG. 14, a tandem solar cell 103 includes: a bottom solar cell 113, the bottom solar cell 113 being the solar cell provided in the foregoing embodiments, the segmented solar cell 110 having a front surface 110c and a back surface 110d opposite to each other along a second direction Y, the segmentation surface 110a connecting the front surface 110c and the back surface 110d along the second direction Y, the second direction Y being a thickness direction of the segmented solar cell 110, and the second direction Y intersecting the first direction X; and a top solar cell 123, the top solar cell 123 being located on the front surface 110c in the bottom solar cell 113.

In some situations, referring to FIG. 6, the segmented solar cell 110 may further include: a base 120, the base 120 having a first main surface 120a facing the second direction Y and a second main surface 120b opposite to the first main surface 120a; a first main passivation film 130 formed on the first main surface 120a; and a first electrode 122. The first electrode 122 extends through the first main passivation film 130 and is in electrical contact with the base 120. In other words, the top solar cell is located on a side of the first main passivation film 130 away from the base 120, and the top solar cell covers a surface of the first main passivation film 130 and a surface of the first electrode 122.

In some embodiments, referring to FIG. 14, the top solar cell 123 may include: a first transport layer, a perovskite base, a second transport layer, a transparent conductive layer, and an antireflection layer that are stacked. The first transport layer directly faces the bottom solar cell 113.

In some embodiments, the first transport layer may be one of an electron transport layer and a hole transport layer, and the second transport layer may be the other one of the electron transport layer and the hole transport layer.

In some embodiments, the tandem solar cell 103 includes, but is not limited to, a crystalline silicon solar cell superimposed on a perovskite solar cell, a crystalline silicon solar cell superimposed on a copper indium gallium selenide solar cell, a crystalline silicon solar cell superimposed on a thin film solar cell, or a crystalline silicon solar cell superimposed on an III-V group solar cell.

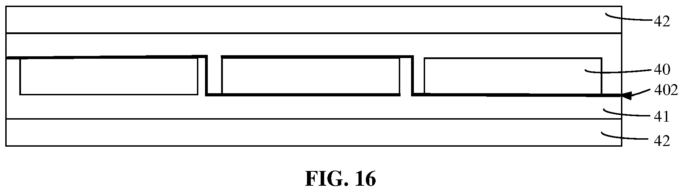

Yet another embodiment of the present disclosure further provides a photovoltaic module. The photovoltaic module includes a plurality of solar cells connected as provided in any of the foregoing embodiments, or a plurality of tandem solar cells connected as provided in the foregoing embodiments. The photovoltaic module is configured to convert received light energy into electrical energy. FIG. 15 is a partial perspective view of a photovoltaic module according to still another embodiment of the present disclosure. FIG. 16 is a cross-sectional structural view taken along a cross-sectional direction MM1 in FIG. 15. It should to be noted that the parts that are the same as or corresponding to the foregoing embodiments, reference may be made to the corresponding descriptions of the foregoing embodiments, which will not be described in detail below.

Referring to FIG. 15 and FIG. 16, the photovoltaic module includes: at least one solar cell string formed by connecting a plurality of solar cells 40 according to any one of above embodiments or formed by connecting a plurality of tandem solar cells 103 (see FIG. 14) according to any one of the above embodiments; at least one packaging adhesive film 41 configured to cover a surface of the at least one solar cell string; and a cover plate 42 configured to cover a surface of the packaging adhesive film 41 away from the at least one solar cell string.

It should to be noted that the solar cells 40 are electrically connected to form a plurality of solar cell strings, and the plurality of solar cell strings are electrically connected in series and/or in parallel. The solar cell 40 includes a plurality of segmented solar cells 110, and the segmented solar cells 110 are formed by segmenting the original solar cell 100. In this way, power loss of the photovoltaic module can be ameliorated by means of reduction in the current of the segmented solar cell 110, so as to improve photoelectric conversion efficiency of photovoltaic module.

In some embodiments, referring to FIG. 16, the plurality of solar cell strings may be electrically connected through conductive strips 402. FIG. 16 only illustrates a positional relationship between one type of solar cells. That is, the solar cell has electrodes with the same polarity arranged in the same direction or electrodes of each solar cell that have a positive polarity are arranged towards the same side, so that the conductive strip connects different sides of two adjacent solar cells respectively. In some embodiments, the solar cells may alternatively face the same side according to electrodes having different polarities. That is, electrodes of a plurality of adjacent solar cells are arranged in order of a first polarity, a second polarity, and a first polarity respectively. Then, the conductive strip connects two adjacent solar cells on the same side.

In some embodiments, there is no gap between the solar cells. That is, the solar cells overlap with each other.

In some embodiments, the packaging adhesive film 41 includes a first packaging layer and a second packaging layer. The first packaging layer covers one of the front surface and the back surface of the solar cell 40, and the second packaging layer covers the other of the front surface and the back surface of the solar cell 40. Specifically, at least one of the first packaging layer and the second packaging layer may be an organic packaging adhesive film such as a polyvinyl butyral (PVB) adhesive film, an ethylenevinyl acetate copolymer (EVA) adhesive film, a polyethylene octene co-elastomer (POE) adhesive film, or a polyethylene terephthalate (PET) adhesive film.

In some situations, there is a dividing line between the first packaging layer and the second packaging layer prior to lamination, and after the lamination, the photovoltaic module is formed and there is no concept of the first packaging layer and the second packaging layer. That is, the first packaging layer and the second packaging layer have formed an entire packaging adhesive film 41.

In some embodiments, the cover plate 42 may be a cover plate with a light-transmitting function such as a glass cover plate or a plastic cover plate. Specifically, a surface of the cover plate 42 facing the packaging adhesive film 41 may have a concave and convex surface, thereby increasing a utilization rate of incident light. The cover plate 42 includes a first cover plate and a second cover plate. The first cover plate is opposite to the first packaging layer, and the second cover plate is opposite to the second packaging layer.

In some embodiments, referring to FIG. 15, the solar cells 40 in the solar cell string are arranged along the first direction X, and busbars of two adjacent solar cells 40 in the solar cell string are staggered in the third direction Z. For the photovoltaic module, the busbars of the two adjacent solar cells 40 in the solar cell string are staggered in the third direction Z, so that different potentials of the photovoltaic module can be tested, thereby improving reliability of test results.

Those of ordinary skill in the art may understand that the above implementations are specific embodiments for implementing the present disclosure, and in practical applications, various changes can be made in form and details without departing from the spirit and scope of the embodiments of the present disclosure. Any person skilled in the art may make various changes and modifications without departing from the spirit and scope of the embodiments of the present disclosure. Therefore, the protection scope of the embodiments of the present disclosure shall be subject to the scope defined by the claims.

## Claims

1. A solar cell formed by a segmented solar cell, comprising:
a passivation stack (101) at least formed on a segmentation surface (110a) of the segmented solar cell (110);
wherein the passivation stack (101) includes at least a first passivation layer (111) and a second passivation layer (121) formed over the first passivation layer (111) in a first direction (X) away from the segmentation surface (110a); and
wherein the first passivation layer (111) includes a silicon oxide material, the second passivation layer (121) includes a metal oxide material, and the metal oxide material includes at least one element of aluminum, titanium, zinc, zirconium, hafnium, molybdenum, tungsten, or nickel.

2. The solar cell according to claim 1, wherein the segmented solar cell (110) is an N-cut solar cell (100) formed by segmenting an original solar cell, N is a positive integer greater than or equal to 2, the segmented solar cell (110) includes at least one segmentation surface (110a), and the passivation stack (101) is formed on each segmentation surface of the at least one segmentation surface (110a).

3. The solar cell according to claim 1, wherein the segmented solar cell (110) includes:
a base (120), the base (120) having a first main surface (120a) facing a second direction (Y) and a second main surface (120b) opposite to the first main surface (120a), wherein the segmentation surface (110a) is between the first main surface (120a) and the second main surface (120b);
a non-segmented side surface between the first main surface (120a) and the second main surface (120b);
a first main passivation film (130) formed on the first main surface (120a);
a second main passivation film (140) formed on the second main surface (120b); and
a side passivation film (150) formed on the non-segmented side surface, the side passivation film (150) including a same material that is included in one of the first main passivation film (130) or the side passivation film (150).

4. The solar cell according to claim 3, wherein the passivation stack (101) is further formed on a part of a surface of the first main passivation film (130) away from the first main surface (120a); and/or
the passivation stack (101) is further formed on a part of a surface of the second main passivation film (140) away from the second main surface (120b).

5. The solar cell according to claim 4, wherein an area ratio of the part of the surface of the first main passivation film (130) provided with the passivation stack (101) to the surface of the first main passivation film (130) is less than or equal to 5%; and/or
an area ratio of the part of the surface of the second main passivation film (140) provided with the passivation stack (101) to the surface of the second main passivation film (140) is less than or equal to 5%.

6. The solar cell according to any one of claims 1 to 5, wherein the passivation stack (101) further includes an intermediate passivation layer (131) formed between the first passivation layer (111) and the second passivation layer (121), the intermediate passivation layer (131) and the first passivation layer (111) both include silicon element, and the intermediate passivation layer (131) and the second passivation layer (121) include a same metal element.

7. The solar cell according to claim 6, wherein the intermediate passivation layer (131) and the first passivation layer (111) include first surfaces (e) in contact with each other, and the intermediate passivation layer (131) and the second passivation layer (121) include second surfaces (f) in contact with each other;
wherein a content of the silicon element at the first surface (e) is higher than a content of the silicon element at the second surface (f), and a content of the metal element at the first surface (e) is lower than a content of the metal element at the second surface (f).

8. The solar cell according to claim 7, wherein along a direction directing from the first passivation layer (111) toward the second passivation layer (121), the content of the silicon element in the intermediate passivation layer (131) substantially represents a decreasing profile, and the content of the metal element in the intermediate passivation layer (131) substantially represents an increasing profile.

9. The solar cell according to claim 6, wherein a thickness of the first passivation layer (111) is less than a thickness of the intermediate passivation layer (131), and the thickness of the intermediate passivation layer (131) is less than a thickness of the second passivation layer (121).

10. The solar cell according to claim 6, wherein a material of the intermediate passivation layer (131) includes an oxide of the silicon element and an oxide of the metal element, in the intermediate passivation layer (131), a content of the silicon element is in a range of 2% to 60%, a content of the metal element is in a range of 2% to 50%, and a content of the oxygen element is in a range of 38% to 50%.

11. The solar cell according to claim 1, wherein in the first passivation layer (111), a content of silicon element is in a range of 60% to 98%, and a content of oxygen element is in a range of 2% to 40%; and
wherein in the second passivation layer (121), a content of metal element is in a range of 45% to 65%, and a content of oxygen element is in a range of 35% to 55%.

12. The solar cell according to claim 1, wherein the first passivation layer (111) includes a third surface (g) away from the second passivation layer (121), and a first surface (e) facing to the second passivation layer (121);
wherein a content of silicon element at the third surface (g) is higher than a content of the silicon element at the first surface (e), and a content of oxygen element at the third surface (g) is lower than a content of the oxygen element at the first surface (e).

13. The solar cell according to claim 1, wherein the second passivation layer (121) includes a fourth surface (h) away from the first passivation layer (111), and a second surface (f) facing to the first passivation layer (111); and
wherein a content of oxygen element at the second surface (f) is higher than a content of the oxygen element at the fourth surface (h), and a content of metal element at the second surface (f) is lower than a content of the metal element at the fourth surface (h).

14. A tandem solar cell (103), including:
a bottom solar cell (113), the bottom solar cell (113) being the solar cell according to any one of claims 1 to 13, the segmented solar cell (110) having a front surface (110c) and a back surface (110d) opposite to each other along a second direction (Y), the segmentation surface (110a) connecting the front surface (110c) and the back surface (110d) along the second direction (Y), the second direction (Y) being a thickness direction of the segmented solar cell (110); and
a top solar cell (123) located on the front surface (110c) in the bottom solar cell (113).

15. A photovoltaic module, including:
at least one solar cell string formed by connecting a plurality of solar cells (40) according to any one of claims 1 to 13 or formed by connecting a plurality of tandem solar cells (103) according to claim 14;
at least one packaging adhesive film (41) configured to cover a surface of the at least one solar cell string; and
at least one cover plate (42) configured to cover a surface of the at least one packaging adhesive film (41) away from the at least one solar cell string.
